(19) **Europäisches Patentamt / European Patent Office / Office européen des brevets**

(11) **EP 4 624 624 A2**

(12) **EUROPEAN PATENT APPLICATION**

(43) Date of publication:
01.10.2025 Bulletin 2025/40

(21) Application number: 25166120.3

(22) Date of filing: 25.03.2025

(51) International Patent Classification (IPC):
C23C 16/04 (2006.01)        C23C 16/34 (2006.01)
C23C 16/455 (2006.01)       H01L 21/285 (2006.01)

(52) Cooperative Patent Classification (CPC):
C23C 16/455; C23C 16/04; C23C 16/34;
H01L 21/28562

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.03.2024  JP 2024050332

(71) Applicant: Kokusai Electric Corporation
Tokyo 101-0045 (JP)

(72) Inventors:
• SAIKI, Junya
Toyama-shi, Toyama, 9392393 (JP)
• JODA, Takuya
Toyama-shi, Toyama, 9392393 (JP)

(74) Representative: Bardehle Pagenberg
Partnerschaft mbB
Patentanwälte Rechtsanwälte
Prinzregentenplatz 7
81675 München (DE)

(54) **METHOD OF PROCESSING SUBSTRATE, METHOD OF MANUFACTURING SEMICONDUCTOR DEVICE, PROGRAM, AND SUBSTRATE PROCESSING APPARATUS**

(57)     There is provided a technique that includes: a) forming a nucleation inhibitor discontinuously, by supplying a first agent to a substrate (200); b) forming a film on a surface of the substrate (200), the surface on which the nucleation inhibitor is formed; c) regulating an amount of the nucleation inhibitor to a first amount; and d) performing a), b), and c) a predetermined number of times.

FIG. 1

**Description**

CROSS-REFERENCE TO RELATED APPLICATION

This application is based upon and claims the benefit of priority from Japanese Patent Application No. 2024-050332, filed on March 26, 2024, the entire contents of which are incorporated herein by reference.

TECHNICAL FIELD

The present disclosure relates to a method of processing a substrate, a method of manufacturing a semiconductor device, a program, and a substrate processing apparatus.

BACKGROUND

In the related art, as a substrate processing process (semiconductor device manufacturing process), a film may be formed on a substrate by supplying a precursor gas, which contains a halogen element, and a reaction gas to the substrate.

SUMMARY

Some embodiments of the present disclosure provide a technique capable of regulating the characteristics of a film.

According to embodiments of the present disclosure, there is provided a technique that includes: a) forming a nucleation inhibitor discontinuously, by supplying a first agent to the substrate; b) forming a film on a surface of the substrate, the surface on which the nucleation inhibitor is formed; c) regulating an amount of the nucleation inhibitor to a first amount; and d) performing a), b), and c) a predetermined number of times.

BRIEF DESCRIPTION OF DRAWINGS

The accompanying drawings, which are incorporated in and constitute a part of the specification, illustrate embodiments of the present disclosure.

FIG. 1 is a longitudinal sectional view showing the outline of a substrate processing apparatus.
FIG. 2 is a schematic cross-sectional view taken along line A-A in FIG. 1.
FIG. 3 is a schematic configuration diagram of a controller of the substrate processing apparatus, in which a control system of the controller is shown in a block diagram.
FIG. 4 is a series of flowcharts including a substrate processing process.
FIG. 5 is a diagram showing the timing of gas supply in a film forming process.
FIG. 6 is a schematic diagram of a mechanism occurring on a substrate in a substrate processing process.
FIG. 7 is a diagram showing an example of an effect of the present disclosure.
FIG. 8 is a diagram showing an example of an effect of the present disclosure.

DETAILED DESCRIPTION

Reference will now be made in detail to various embodiments, examples of which are illustrated in the accompanying drawings. In the following detailed description, numerous specific details are set forth in order to provide a thorough understanding of the present disclosure. However, it will be apparent to one of ordinary skill in the art that the present disclosure may be practiced without these specific details. In other instances, well-known methods, procedures, systems, and components have not been described in detail so as not to unnecessarily obscure aspects of the various embodiments.

<Embodiments of the Present Disclosure>

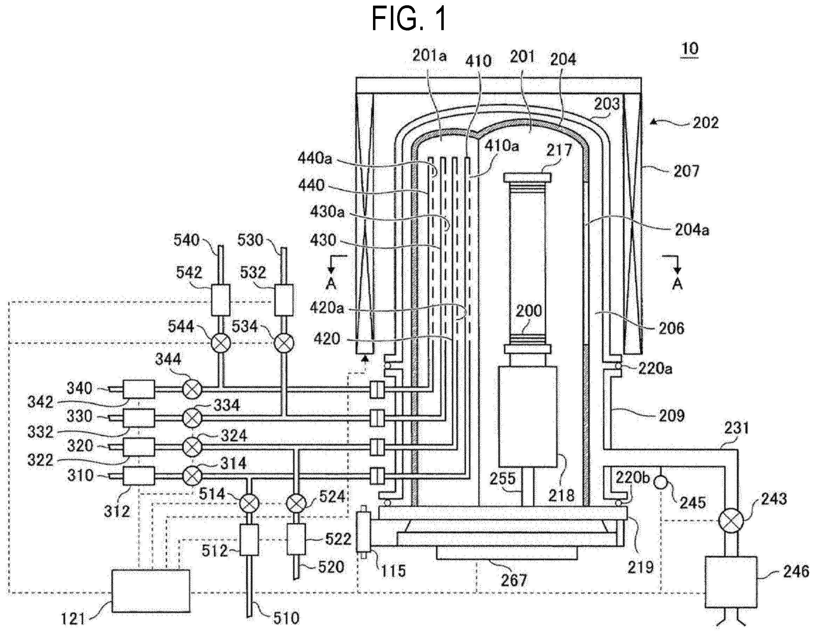

Embodiments of the present disclosure will now be described mainly with reference to FIGS. 1 to 8. The drawings used in the following description are all schematic, and the dimensional relationship, ratios, and the like of various elements shown in the drawings do not always match the actual ones. Further, the dimensional relationship, ratios, and the like of various elements between plural figures do not always match each other.

(1) Configuration of Substrate Processing Apparatus

A substrate process apparatus 10 includes a process furnace 202 in which a heater 207 as a heating means (a heating mechanism or a heating system) is provided. The heater 207 has a cylindrical shape and is supported by a heat base (not shown) as a support plate so as to be vertically installed.

An outer tube 203 forming a process container is disposed inside the heater 207 to be concentric with the heater 207. The outer tube 203 is made of, for example, a heat resistant material such as quartz or silicon carbide (SiC) and has a cylindrical shape with its upper end closed and its lower end opened. A manifold 209 (hereinafter referred to as MF 209) is disposed below the outer tube 203 to be concentric with the outer tube 203. The MF 209 is made of, for example, metal such as stainless steel and is formed in a cylindrical shape with its upper and lower ends opened. An O-ring 220a serving as a seal member is installed between the upper end portion of the MF 209 and the outer tube 203. When the MF 209 is supported by the heater base, the outer tube 203 is in a state of being installed vertically.

An inner tube 204 forming the process container is disposed inside the outer tube 203. The inner tube 204 is made of, for example, a heat resistant material such as quartz or SiC and is formed in a cylindrical shape with its upper end closed and its lower end opened. The process container mainly includes the outer tube 203, the inner tube 204, and the MF 209. A process chamber 201 is formed in a hollow cylindrical portion (inside the inner tube 204) of the process container.

The process chamber 201 is configured to be able to accommodate wafers 200 as substrates in a state where the wafers 200 are arranged in a horizontal posture and in multiple stages in the vertical direction by a boat 217 which will be described later.

Nozzles 410, 420, 430, and 440 are provided in the process chamber 201 so as to penetrate through a sidewall of the MF 209 and the inner tube 204. Gas supply pipes 310, 320, 330, and 340 are connected to the nozzles 410, 420, 430, and 440, respectively. However, the process furnace 202 of the embodiments is not limited to the above-mentioned form.

Mass flow controllers (MFCs) 312, 322, 332, and 342, which are flow rate controllers (flow rate control parts), and valves 314, 324, 334, and 344, which are opening/closing valves, are provided in the gas supply pipes 310, 320, 330, and 340, respectively, sequentially from the upstream side. Gas supply pipes 510, 520, 530, and 540 for supplying an inert gas are connected at the downstream side of the valves 314, 324, 334, and 344 of the gas supply pipes 310, 320, 330, and 340, respectively. MFCs 512, 522, 532, and 542, which are flow rate controllers (flow rate control parts), and valves 514, 524, 534, and 544, which are opening/closing valves, are provided in the gas supply pipes 510, 520, 530, and 540, respectively, sequentially from the upstream side.

The nozzles 410, 420, 430, and 440 are connected to the leading ends of the gas supply pipes 310, 320, 330, and 340, respectively. The nozzles 410, 420, 430, and 440 are configured as L-shaped nozzles, and their horizontal portions are formed so as to penetrate through the sidewall of the MF 209 and the inner tube 204. The vertical portions of the nozzles 410, 420, 430, and 440 are formed inside a channel-shaped (groove-shaped) preliminary chamber 201a formed so as to protrude outward in the radial direction of the inner tube 204 and extend in the vertical direction thereof and are also formed in the preliminary chamber 201a upward (upward in the arrangement direction of the wafers 200) along the inner wall of the inner tube 204.

The nozzles 410, 420, 430, and 440 are provided so as to extend from a lower region of the process chamber 201 to an upper region of the process chamber 201, and a plurality of gas supply holes 410a, 420a, 430a, and 440a are formed at positions facing the wafers 200, respectively. Thus, a process gas is supplied from the gas supply holes 410a, 420a, 430a, and 440a of the respective nozzles 410, 420, 430, and 440 to the wafers 200. A plurality of gas supply holes 410a, 420a, 430a, and 440a are formed from a lower portion of the inner tube 204 to an upper portion thereof and have the same aperture area at the same aperture pitch. However, the gas supply holes 410a, 420a, 430a, and 440a are not limited to the above-described shape. For example, the aperture area may be gradually increased from the lower portion of the inner tube 204 to the upper portion thereof. This makes it possible to make the flow rate of a gas supplied from the gas supply holes 410a, 420a, 430a, and 440a more uniform.

The plurality of gas supply holes 410a, 420a, 430a, and 440a of the nozzles 410, 420, 430, and 440 are formed at height positions from a lower portion of the boat 217, which will be described later, to an upper portion thereof. Therefore, the process gas supplied into the process chamber 201 from the gas supply holes 410a, 420a, 430a, and 440a of the nozzles 410, 420, 430, and 440 is supplied to the entire region of the wafers 200 accommodated from the lower portion of the boat 217 to the upper portion thereof. The nozzles 410, 420, 430, and 440 are provided so as to extend from the lower region of the process chamber 201 to the upper region thereof, but may be provided so as to extend to the vicinity of the ceiling of the boat 217.

As a first material (precursor or process gas), a first element-containing gas containing a first element is supplied from the gas supply pipe 310 into the process chamber 201 via the MFC 312, the valve 314, and the nozzle 410.

As a first reactant (process gas), a first reducing gas is supplied from the gas supply pipe 320 into the process chamber 201 via the MFC 322, the valve 324, and the nozzle 420.

As a second reactant (process gas), a second reducing gas different from the first reducing gas is supplied from the gas supply pipe 330 into the process chamber 201 via the MFC 332, the valve 334, and the nozzle 430. In the present disclosure, the second reducing gas is used as a reactant gas that reacts with a precursor gas.

A nucleation inhibiting agent (modifying agent or process gas) is supplied from the gas supply pipe 340 into the process chamber 201 via the MFC 342, the valve 344, and the nozzle 440. The term "agent" used in the present disclosure includes at least one of a gaseous substance and a liquid substance. The liquid substance includes a misty substance. That is, a film forming agent, a modifying agent, and an etching agent may include a gaseous substance, may include a liquid substance such as a misty substance, or may include both.

As an inert gas, for example, a nitrogen ($N_2$) gas, is supplied from the gas supply pipes 510, 520, 530, and 540 from the process chamber 201 via the MFCs 512, 522, 532, and 542, the valves 514, 524, 534, and 544, and the nozzles 410, 420, 430, and 440, respectively. Hereinafter, an example in which the $N_2$ gas is used as the inert gas will be described. However, as the inert gas, in addition to the $N_2$ gas, it may be possible to use, e.g., a rare gas such as an Ar gas, a He gas, a Ne gas, a Xe gas, or the like.

A process gas supply system mainly includes the gas supply pipes 310, 320, 330, and 340, the MFCs 312, 322, 332, and 342, the valves 314, 324, 334, and 344, and the nozzles 410, 420, 430, and 440. However, the process gas supply system may include only the nozzles 410, 420, 430, and 440. The process gas supply system may be simply referred to as a gas supply system. When the first material is flowed from the gas supply pipe 310, a first material supply system mainly includes the gas supply pipe 310, the MFC 312, and the valve 314. However, the first material supply system may include the nozzle 410. Further, when the first reactant is flowed from the gas supply pipe 320, a first reactant supply system mainly includes the gas supply pipe 320, the MFC 322, and the valve 324. However, the first reactant supply system may include the nozzle 420. Further, when the second reactant is flowed from the gas supply pipe 330, a second reactant supply system mainly includes the gas supply pipe 330, the MFC 332, and the valve 334. However, the second reactant supply system may include the nozzle 430. When the second reactant is supplied as a reactant gas from the gas supply pipe 330, the second reactant supply system may be referred to as a reactant gas supply system. Further, when the modifying agent is flowed from the gas supply pipe 340, a modifying agent supply system mainly includes the gas supply pipe 340, the MFC 342, and the valve 344. However, the modifying agent supply system may include the nozzle 440. Further, an inert gas supply system mainly includes the gas supply pipes 510, 520, 530, and 540, the MFCs 512, 522, 532, and 542, and the valves 514, 524, 534, and 544.

A method of supplying a gas in the embodiments is to supply a gas via the nozzles 410, 420, 430, and 440 arranged in the preliminary chamber 201a in an annular vertically long space defined by the inner wall of the inner tube 204 and the ends of a plurality of wafers 200. Then, the gas is ejected into the inner tube 204 from the plurality of gas supply holes 410a, 420a, 430a, and 440a formed at positions of the nozzles 410, 420, 430, and 440, which face the wafers.

An exhaust hole (exhaust port) 204a is an opening formed in a sidewall of the inner tube 204 at a position facing the nozzles 410, 420, 430, and 440. The shape of the opening is, for example, a slit shape. A gas supplied into the process chamber 201 from the gas supply holes 410a, 420a, 430a, and 440a of the nozzles 410, 420, 430, and 440 and flowing on the surface of the wafers 200 passes through the exhaust hole 204a and flows into an exhaust passage 206 consisting of a gap formed between the inner tube 204 and the outer tube 203. Then, the gas flowed into the exhaust passage 206 flows into an exhaust pipe 231 and is discharged to the outside of the process furnace 202.

The exhaust hole 204a is formed at a position facing the plurality of wafers 200, and a gas supplied from the gas supply holes 410a, 420a, 430a, and 440a to the vicinity of the wafers 200 in the process chamber 201 flows toward the horizontal direction and then flows into the exhaust passage 206 through the exhaust hole 204a. The exhaust hole 204a is not limited to the slit-shaped through-hole, but may be configured by a plurality of holes.

The exhaust pipe 231 for exhausting an internal atmosphere of the process chamber 201 is provided in the MF 209. A pressure sensor 245, which is a pressure detector (pressure detecting part) for detecting an internal pressure of the process chamber 201, an auto pressure controller (APC) valve 243, and a pump 246 as a vacuum-exhausting device, are connected to the exhaust pipe 231 sequentially from the upstream side. The APC valve 243 can exhaust or stop exhausting the internal atmosphere of the process chamber 201 by opening or closing the valve while the pump 246 is actuated, and can also regulate the internal pressure of the process chamber 201 by regulating an opening degree of the valve while the pump 246 is actuated. An exhaust system mainly includes the exhaust hole 204a, the exhaust passage 206, the exhaust pipe 231, the APC valve 243, and the pressure sensor 245. The exhaust system may include the pump 246.

A seal cap 219 (hereinafter referred to as SC 219) serving as a furnace opening cover that can hermetically seal a lower end opening of the MF 209 is provided under the MF 209. The SC 219 is configured to come into contact with the lower end of the MF 209 from the lower side in the vertical direction. The SC 219 is made of, for example, metal such as stainless steel (SUS), and is formed in a disc shape. An O-ring 220b as a seal member making contact with the lower end of the MF 209 is provided on an upper surface of the SC 219. A rotator 267 for rotating the boat 217 in which the wafers 200 are accommodated is installed on the opposite side of the process chamber 201 in the SC 219. A rotary shaft 255 of the rotator 267 penetrates through the SC 219 and is connected to the boat 217. The rotator 267 is configured to rotate the wafers 200 by rotating the boat 217. The SC 219 is configured to be vertically moved up and down by a boat elevator 115 (hereinafter referred to as BE 115) as an elevation mechanism vertically installed outside the outer tube 203. The BE 115 is configured to be able to load/unload the boat 217 into/out of the process chamber 201 by moving the SC 219 up and down. The BE 115 is configured as a transfer device (transfer system) which transfers the boat 217 and the wafers 200 accommodated in the boat 217 into/out of the process chamber 201.

The boat 217 serving as a substrate support is configured to arrange a plurality of wafers 200, for example, 10 to 200 wafers 200, at intervals in the vertical direction in a horizontal posture with the centers of the wafers 200 aligned with one another. The boat 217 is made of, for example, a heat resistant material such as quartz or SiC. Heat insulating plates 218 made of, for example, a heat resistant material such as quartz or SiC, are installed in a horizontal posture and in multiple stages (not shown) below the boat 217. This configuration makes it difficult to transfer heat from the heater 207 to the SC 219 side. However, the embodiments is not limited to the above-described form. For example, instead of installing the heat insulating plates 218, a heat insulating cylinder configured as a cylindrical member made of a heat resistant material such as quartz or SiC may be installed below the boat 217.

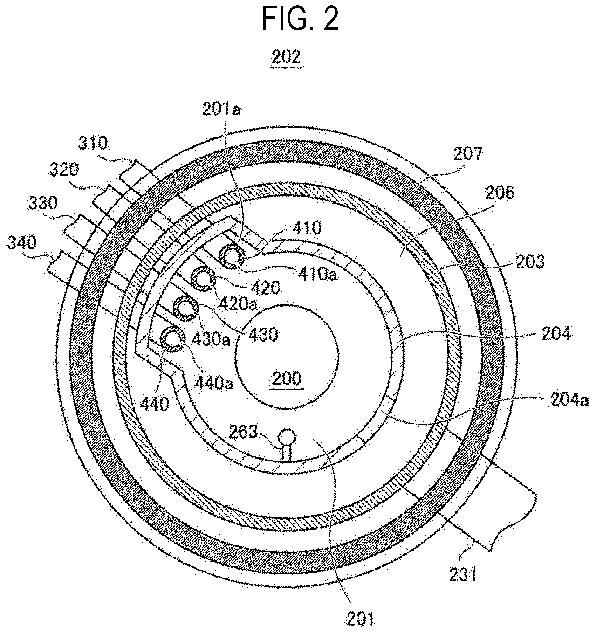

As shown in FIG. 2, a temperature sensor 263 serving as a temperature detector is installed in the inner tube 204. Based on temperature information detected by the temperature sensor 263, a state of supplying electric power to the heater 207 is regulated such that the interior of the process chamber 201 has a desired temperature distribution. The temperature sensor 263 is configured as an L-shape, like the nozzles 410, 420, 430, and 440, and is provided along the inner wall of the inner tube 204.

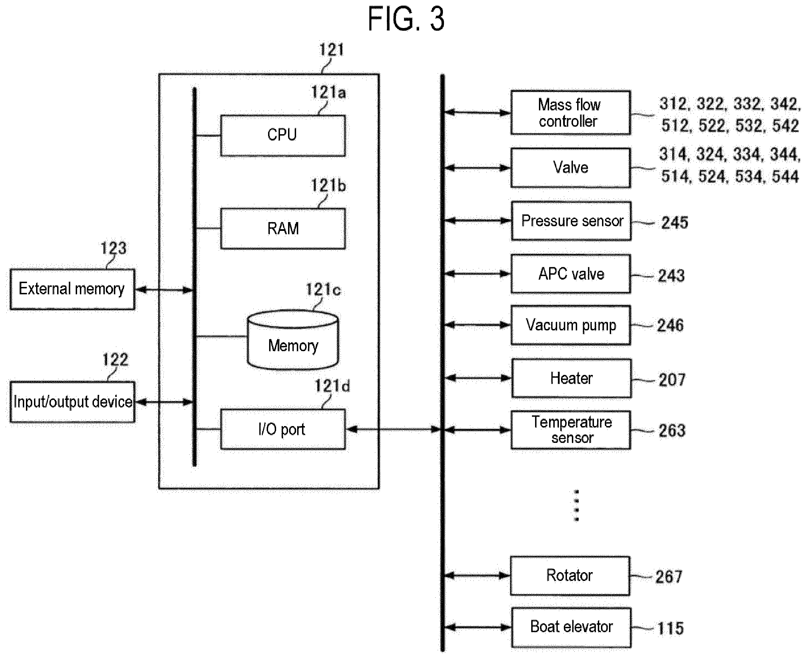

As shown in FIG. 3, a controller 121, which is a control part (control means), is configured as a computer including a central processing unit (CPU) 121a, a random access memory (RAM) 121b, a memory 121c, and an I/O port 121d. The RAM 121b, the memory 121c, and the I/O port 121d are configured to be capable of exchanging data with the CPU 121a via an internal bus. An input/output device 122 formed of, e.g., a touch panel or the like, is connected to the controller 121.

The memory 121c is configured by, for example, a flash memory, a hard disk drive (HDD), or the like. A control program for controlling operations of a substrate processing apparatus and a process recipe in which sequences and conditions of a method of manufacturing a semiconductor device, which will be described later, are written, are readably stored in the memory 121c. The process recipe functions as a program for causing the controller 121 to execute each step in the method of manufacturing a semiconductor device, which will be described later, to obtain a predetermined result. Hereinafter, the process recipe and the control program may be generally and simply referred to as a "program". When the term "program" is used herein, it may indicate a case of including the process recipe only, a case of including the control program only, or a case of including a combination of the process recipe and the control program. The RAM 121b is configured as a memory area (work area) in which a program or data read by the CPU 121a is temporarily stored.

The I/O port 121d is connected to the MFCs 312, 322, 332, 342, 512, 522, 532, and 542, the valves 314, 324, 334, 344, 514, 524, 534, and 544, the pressure sensor 245, the APC valve 243, the pump 246, the heater 207, the temperature sensor 263, the rotator 267, the BE 115, and the like.

The CPU 121a is configured to read and execute the control program from the memory 121c. The CPU 121a is also configured to read the recipe from the memory 121c according to an input of an operation command from the input/output device 122. The CPU 121a is configured to be capable of controlling the flow rate regulation operation of various kinds of gases by the MFCs 312, 322, 332, 342, 512, 522, 532, and 542, the opening/closing operation of the valves 314, 324, 334, 344, 514, 524, 534, and 544, the opening/closing operation of the APC valve 243, the pressure regulating operation performed by the APC valve 243 based on the pressure sensor 245, the temperature regulating operation performed by the heater 207 based on the temperature sensor 263, the actuating and stopping of the pump 246, the operation of rotating the boat 217 with the rotator 267 and regulating the rotation speed of the boat 217, the operation of moving the boat 217 up and down by the BE 115, the operation of accommodating the wafers 200 in the boat 217, and the like, according to contents of the read recipe.

The controller 121 may be configured by installing, on the computer, the aforementioned program stored in an external memory (for example, a magnetic disk such as a hard disk, an optical disc such as a CD or a DVD, or a semiconductor memory such as a flash memory) 123. The memory 121c and the external memory 123 are configured as a non-transitory computer-readable recording medium. Hereinafter, the memory 121c and the external memory 123 may be generalized and simply referred to as a "recording medium". When the term "recording medium" is used herein, it may indicate a case of including the memory 121c only, a case of including the external memory 123 only, or a case of including both the memory 121c and the external memory 123. The program (program product) may be provided to the computer using a communication means such as the Internet or a dedicated line, instead of using the external memory 123.

(2) Substrate Processing Process (Substrate Processing Method)

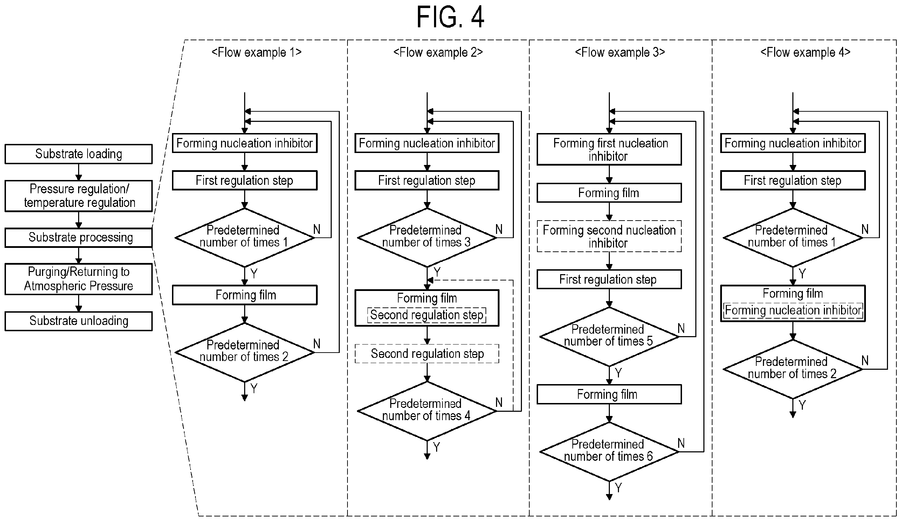

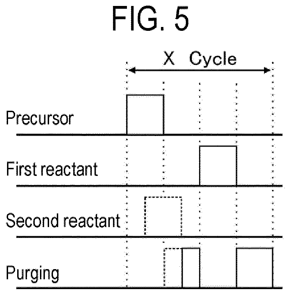

As a process of manufacturing a semiconductor device, an example of a process of forming a first element-containing film containing a first element on a wafer 200 will be described with reference to FIGS. 4 and 5. This process is performed using the process furnace 202 of the above-described substrate processing device 10. In the following description, the operations of various parts constituting the substrate processing apparatus 10 are controlled by the controller 121. FIG. 4 shows four flow examples: flow example 1, flow example 2, flow example 3, and flow example 4, as a substrate processing process. FIG. 5 shows the timings of precursor supply, first reactant supply, second reactant supply, and purge in a film forming process.

A substrate processing process (device manufacturing process) according to the embodiments includes:

a) a step of discontinuously forming a nucleation inhibitor by supplying a first agent to a wafer 200;
b) a step of forming a film on the surface of the wafer 200 on which the nucleation inhibitor is formed;
c) a step of regulating the amount of nucleation inhibitor to a first amount; and
d) a step of performing a), b), and c) a predetermined number of times.

When the term "wafer" is used in the present disclosure, it may refer to "a wafer itself" or "a wafer and a laminated body of certain layers or films formed on a surface of a wafer". When the phrase "a surface of a wafer" is used in the present disclosure, it may refer to "a surface of a wafer itself" or "a surface of a certain layer or film formed on a wafer". When the term "substrate" is used in the present disclosure, it is synonymous with the term "wafer".

(Wafer (Substrate) Loading)

When a plurality of wafers 200 are placed on the boat 217, as shown in FIG. 1, the boat 217 supporting the plurality of wafers 200 is lifted up by the BE 115 to be loaded into the process chamber 201 of the process container and accommodated in the process container.

(Pressure Regulation and Temperature Regulation)

The interior of the process chamber 201, i.e., a space in which the wafers 200 are placed, is vacuum-exhausted by the pump 246 to reach a desired pressure. At this time, the internal pressure of the process chamber 201 is measured by the pressure sensor 245. The APC valve 243 is feedback-controlled based on the measured pressure information (pressure regulation). The pump 246 always keeps in operation at least until processing on the wafers 200 is completed. The interior of the process chamber 201 is heated by the heater 207 to a desired temperature. At this time, the state of supplying electric power to the heater 207 is feedback-controlled based on the temperature information detected by the temperature sensor 263 such that the interior of the process chamber 201 has a desired temperature distribution (temperature regulation). Heating the interior of the process chamber 201 by the heater 207 may be continuously performed at least until the processing on the wafers 200 is completed.

(Nucleation Inhibitor Forming Step) (see Flow Example 1)

The valve 344 is opened to allow a nucleation inhibiting agent to flow into the gas supply pipe 340. The nucleation inhibiting agent, the flow rate of which is regulated by the MFC 342, is supplied from the gas supply hole 440a of the nozzle 440 into the process chamber 201. The nucleation inhibiting agent in the process chamber 201 is exhausted through the exhaust pipe 231.

At this time, the APC valve 243 is regulated to set the internal pressure of the process chamber 201 to be, for example, within a range of 1 to 3,990Pa. The supply flow rate of the nucleation inhibiting agent controlled by the MFC 342 is set to be, for example, within a range of 0.01 to 3slm. In the following, the temperature of the heater 207 is set to a temperature such that the temperature of the wafer 200 is be, for example, within a range of 200 to 600 degrees C. In addition, in the present disclosure, the expression of a numerical range such as "1 to 3,990Pa" means that the lower limit and the upper limit are included in the range. Therefore, for example, "1 to 3,990 Pa" means "1Pa or more and 3,990Pa or less". The same applies to other numerical ranges.

At this time, the nucleation inhibiting agent is supplied to the wafer 200. The nucleation inhibiting agent is, for example, a halogen element-containing agent. The halogen element is chlorine (Cl), fluorine (F), iodine (I), and bromine (Br). Specific examples of the halogen element-containing agent may include $F_2$, $NF_3$, $Cl_2$, $ClF_3$, $Br_2$, $I_2$, HCl, HBr, HI, $BCl_3$, $WF_6$, $WCl_6$, $MoCl_3$, and $MoCl_5$. Preferably, a gas containing fluorine can be used as the nucleation inhibiting agent. In addition, preferably, a gas not containing a metal element can be used as the nucleation inhibiting agent. By supplying the nucleation inhibiting agent to the wafer 200, the molecules themselves constituting the fluorine-containing gas or some of the molecules (e.g., molecules containing the halogen element) are adsorbed on the wafer 200 (a base film on the surface of the wafer 200) as a nucleation inhibitor. For example, when a $NF_3$ gas, which is an example of the fluorine-containing gas, is used as the nucleation inhibiting agent, $NF_x$ (x is an integer of 3 or less) and F are adsorbed on the wafer 200.

At this time, the valve 544 may be opened to allow an inert gas (dilution gas) to be supplied from the gas supply pipe 540 to the gas supply pipe 340 to dilute the nucleation inhibiting agent. By regulating the flow rate of the inert gas with the MFC 542, the concentration (partial pressure) of the nucleation inhibiting agent can be regulated.

After forming the nucleation inhibiting agent on the wafer 200, the valve 344 is closed.

(Regulation Step)

Subsequently, the nucleation inhibitor on the wafer 200 is regulated. Here, regulating the nucleation inhibitor means regulating the state of the nucleation inhibitor on the wafer 200. For example, it means regulating the amount of nucleation inhibitor, the molecular (atomic) state of the nucleation inhibitor, the termination of the nucleation inhibitor, etc. The step of regulating the state of the nucleation inhibitor is also simply referred to as a regulation step, a treating step, or a modifying step. In addition, a plurality of regulation steps may be performed. A plurality of types of regulation steps may be combined. When two types of regulation steps are performed, they are also referred to as a first regulation step and a second regulation step, or a first treating step and a second treating step.

The regulation step includes, for example, the following inert gas supplying step, exhausting step, and first regulation step.

(Inert Gas Supplying Step (Purging))

First, the valves 514, 524, 534, and 544 are opened to allow an inert gas to flow into the gas supply pipes 510, 520, 530, and 540, respectively. That is, the inert gas is supplied into the process chamber 201. This allows the nucleation inhibiting agent remaining in the process chamber 201 to be pushed out to the exhaust pipe 231. In this process, the amount of molecules of the nucleation inhibiting agent present on the wafer 200 can be reduced. The inert gas supplying step is also simply referred to as a purging step.

At this time, the APC valve 243 is regulated to set the internal pressure of the process chamber 201 to be, for example, within a range of 1 to 3,990Pa. The supply flow rate of the inert gas controlled by the MFCs 512, 522, 532, and 542 is set to be, for example, within a range of 0.1 to 30slm. At this time, the time for which the inert gas is supplied to the wafer 200 is set to be, for example, within a range of 0.1 to 30 seconds.

(Exhausting Step)

In an exhausting step, the valves 514, 524, 534, and 544 are closed to stop the supply of the inert gas. At this time, the APC valve 243 of the exhaust pipe 231 is opened, and the interior of the process chamber 201 is vacuum-exhausted by the pump 246. This removes a residual gas from above the wafer 200 to remove a gas, reaction by-products, and the like remaining in the process chamber 201 from the interior of the process chamber 201. As a result, the residual gas is removed from above the wafer 200, so that the amount of nucleation inhibitor on the wafer 200 can be reduced. At this time, the time for which the interior of the process chamber 201 is vacuum-exhausted is set to be, for example, within a range of 0.1 to 30 seconds.

(First Regulation Step)

As a first regulation step, for example, there is a step of supplying a regulating agent to the wafer 200. The regulating agent is also referred to as a modifying agent, a treating agent, etc. In the present disclosure, the above-mentioned inert gas may also be referred to as a regulating agent. In this case, the regulating agent supplied in the first regulation step may also be referred to as a reaction regulating agent.

In the first regulation step, the valve 324 is opened to allow a regulating agent to flow into the gas supply pipe 320. The regulating agent, the flow rate of which is regulated by the MFC 322, is supplied from the gas supply hole 420a of the nozzle 420 into the process chamber 201 and is exhausted through the exhaust pipe 231. This results in the regulating agent being supplied to the wafer 200.

At this time, the APC valve 243 is regulated to set the internal pressure of the process chamber 201 to be, for example, within a range of 0.01 to 3,990Pa. The supply flow rate of the regulating agent controlled by the MFC 322 is set to be, for example, within a range of 0.01 to 5slm. At this time, the time for which an inert gas is supplied to the wafer 200 is set to be, for example, within a range of 0.01 to 60 seconds.

At this time, the valves 514, 524, 534, and 544 may be opened to allow an inert gas to flow into the gas supply pipes 510, 520, 530, and 540, respectively. By supplying the inert gas, the concentration (partial pressure) of the modifying agent can be regulated. The supply flow rate of the inert gas controlled by the MFCs 512, 522, 532, and 542 is set to be, for example, within a range of 0.01 to 5slm. At this time, the time for supplying the inert gas to the wafer 200 is set to be, for example, within a range of 0.1 to 60 seconds.

As the regulating agent, for example, a material capable of reacting with the nucleation inhibiting agent is used. When a material containing a halogen element is used as the nucleation inhibiting agent, a material containing an element capable of reacting with the halogen element can be used as the regulating agent. As such a material, for example, a material containing a group containing H, such as hydrogen (H), a NH-group, or an OH-group, can be used. As specific materials, at least one of $H_2$, deuterium (D), $NH_3$, $N_2H_2$, $N_2H_4$, $H_2O$, $H_2+O_2$, and $H_2+N_2$ can be used. A gas containing oxygen can also be used. Specifically, at least one of $O_2$, $O_3$, $H_2O$, $H_2+O_2$, $H_2O_2$, and $N_2O$ can be used. A gas in which at least one of these materials is activated can also be used. These gases can also be used in combination. Preferably, a gas containing H can be used. This is because H has a relatively high reactivity with the halogen element. Preferably, a gas containing nitrogen (N) and H can also be used. More preferably, a gas containing a NH-group can be used. Preferably, a gas containing H and O can also be used. The regulating agent can be the same gas as a first reactant and a second reactant to be described later. Gases different from the first reactant and the second reactant to be described later may also be used. By using such a regulating agent, the amount of halogen element can be regulated.

As the regulation step, when, for example, a gas containing a NH-group is supplied to the wafer 200, at least a portion of $NF_x$ present on the wafer 200 reacts with the NH-group, so that the amount of fluorine-containing substance (fluorine element) present on the wafer 200 can be reduced.

In addition, in the modifying step in which a modifying agent that modifies the surface of the wafer 200 is supplied, the temperature of the wafer 200 may be configured to be different from the temperature of the wafer 200 in the nucleation inhibitor forming step. By making the temperatures different, it becomes easier to regulate the nucleation inhibitor to a desired state. For example, the temperature of the wafer 200 in the modifying step is made higher than the temperature of the wafer 200 in the nucleation inhibitor forming step. When the temperature of the wafer 200 is made higher, the modifying step is also referred to as an annealing step. By making the temperature of the wafer 200 higher, it is possible to promote the desorption of the nucleation inhibitor and the reaction with the regulating agent. The modifying step can also be performed without changing the temperature of the wafer 200. By not changing the temperature, the temperature regulation time can be eliminated, and the time required for the entire substrate processing process can be shortened. In other words, the manufacturing throughput of semiconductor devices can be improved.

The amount of nucleation inhibitor formed on the wafer 200 is regulated to a first amount.

(Performing Predetermined Number of Times)

The amount of nucleation inhibitor on the wafer 200 can be reduced by performing the inert gas supply and the exhausting step a predetermined number of times. In addition, the inert gas supply, the exhausting step, and the modifying step may be performed a predetermined number of times. Here, the predetermined number of times is an integer of 1 or 2 or more. Examples of the sequence may include the following patterns.

(A)

$$(\text{Inert gas supply} \rightarrow \text{Exhaust step}) \times \text{Predetermined number of times}$$

(B) Modifying agent supply

(C)

$$[(A) \rightarrow (B)] \times \text{Predetermined number of times}$$

(D)

$$[(B) \rightarrow (A)] \times \text{Predetermined number of times}$$

(Predetermined Number of Times)

The nucleation inhibitor forming step and the nucleation inhibitor regulation step are performed a predetermined number of times. Here, the predetermined number of times is an integer of 1 or 2 or more. By performing the steps two or more times, the uniformity of the state of the nucleation inhibitor within the in-plane of the wafer 200 can be improved.

(Film-Forming Step)

After the regulation step, a film-forming step is performed.

(Supply of First Material)

The valve 314 is opened to allow a precursor to flow into the gas supply pipe 310. The precursor, the flow rate of which is regulated by the MFC 312, is supplied from the gas supply hole 410a of the nozzle 410 into the process chamber 201 and is exhausted through the exhaust pipe 231.

At this time, the APC valve 243 is regulated to set the internal pressure of the process chamber 201 to be, for example, within a range of 1 to 3,990Pa. The supply flow rate of the precursor controlled by the MFC 312 is set to be, for example, within a range of 0.01 to 3slm.

At this time, the precursor is supplied to the wafer 200. By supplying the precursor to the wafer 200, a material containing a first element is adsorbed on the wafer 200 (a base film on the surface of the wafer 200). Here, since the nucleation inhibitor is formed on the wafer 200, the material containing the first element is adsorbed to a location where the nucleation inhibitor is not formed. The first element is, for example, at least one of titanium (Ti), zirconium (Zr), hafnium (Hf), molybdenum (Mo), ruthenium (Ru), aluminum (Al), gallium (Ga), silicon (Si), germanium (Ge), and the like. As the precursor, a gas containing the first element and a halogen element can be used. The halogen element is, for example, at least one of chlorine (Cl), fluorine (F), and bromine (Br). As such a gas, for example, one or more of $WCl_6$, $WF_6$, $TiF_4$, $MoCl_5$, $MoF_5$, $MoO_2Cl_2$, $RuCl_3$, $RuF_3$, $HfCl_4$, $HfF_4$, $ZrCl_4$, $ZrF_4$, $AlCl_3$, $AlF_3$, $SiH_2Cl_2$, $Si_2Cl_6$, etc. can be used. In the present disclosure, a case where a $TiCl_4$ gas is used as the precursor will be described. When the $TiCl_4$ gas is used as the precursor, $TiCl_x$ (x is an integer of 4 or less) is adsorbed on the wafer 200 (the base film on the surface of the wafer 200) to form a Ti-containing layer by supplying the $TiCl_4$ gas.

(Simultaneous Supply of Precursor and Second Reactant)

As shown by a broken line in FIG. 5, a second reactant may be supplied in parallel with the supply of the precursor. When the second reactant is supplied, the valve 334 is opened to allow the second reactant to flow into the gas supply pipe 330. The flow rate of the second reactant is regulated by the MFC 332, and the second reactant is supplied from the gas supply hole 430a of the nozzle 430 into the process chamber 201 and is exhausted through the exhaust pipe 231.

At this time, the APC valve 243 is regulated to set the internal pressure of the process chamber 201 to be, for example, within a range of 1 to 3,990Pa. The supply flow rate of a third reducing gas controlled by the MFC 332 is set to be, for example, within a range of 1 to 10slm. The time during which the precursor and the second reactant are supplied in parallel to the wafer 200 is set to be, for example, within a range of 0.01 to 70 seconds.

At this time, the precursor and the second reactant are supplied to the wafer 200. That is, there is a timing at which at least the precursor and the second reactant are supplied simultaneously. As the second reactant, for example, a gas containing at least one of group XIII element and group XIV element of the periodic table and hydrogen can be used. Examples of such a gas may include silane-based gases such as $SiH_4$, $Si_2H_6$, and $Si_3H_8$, and borane-based gases such as $BH_3$ and $B_2H_6$. In the following description, a case where $SiH_4$ is used as the second reactant will be described.

By supplying the second reactant in this manner, reaction by-products, such as hydrogen chloride (HCl), which is an adsorption inhibiting gas that inhibits film formation, are removed. Then, reaction by-products such as HCl that have been adsorbed in locations where the nucleation inhibitors are not adsorbed can be removed. This opens up adsorption sites on the wafer 200 where the precursor can be adsorbed, so that adsorption sites where the precursor such as $TiCl_x$ can be adsorbed can be formed on the surface of the wafer 200. Here, the adsorption sites where the precursor can be adsorbed refer to locations (areas) on the wafer 200 where the nucleation inhibitors are not adsorbed.

(Stopping Supply of Precursors and Continuing Supply of Second Reactant)

After a predetermined time elapsed since the supply of the precursor was started, the valve 314 is closed to stop the supply of the precursor. In other words, the supply of the precursor is stopped in the middle of the supply of the second reactant, while the second reactant is being supplied after a predetermined time elapsed since the supply of the second reactant was started.

At this time, the APC valve 243 is regulated to set the internal pressure of the process chamber 201 to be, for example, within a range of 1 to 3,990Pa. The time during which only the first reducing gas and the third reducing gas are simultaneously supplied to the wafer 200 is set to be, for example, within a range of 0.1 to 30 seconds.

At this time, the second reactant is supplied to the wafer 200.

In this way, by stopping the supply of the precursor while the second reactant is being supplied and stopping the supply of the second reactant after a predetermined time elapsed since the supply of the precursor was stopped, the amount of reaction by-products remaining in the process chamber 201 can be reduced so that the film quality of the first element-containing film, for example, a titanium nitride (TiN) film, can be improved.

(Supply of Inert Gas (Purging))

After a predetermined time elapsed since the supply of the second reactant was started, the valve 334 is closed to stop the supply of the second reactant. At this time, the valves 514, 524, 534, and 544 are opened to allow an inert gas to flow into the gas supply pipes 510, 520, 530, and 540 (purging), respectively. That is, the inert gas is supplied into the process chamber 201.

At this time, the APC valve 243 is regulated to set the internal pressure of the process chamber 201 to be, for example, within a range of 1 to 3,990Pa. The supply flow rate of the inert gas controlled by the MFCs 512, 522, 532, and 542 is set to be, for example, within a range of 0.1 to 30slm.

(Exhausting Step)

After a predetermined time elapsed since the supply of the inert gas was started, the valves 514, 524, 534, and 544 are closed to stop the supply of the inert gas. At this time, the APC valve 243 of the exhaust pipe 231 is opened to vacuum-exhaust the interior of the process chamber 201 by the pump 246. Therefore, a residual gas is removed from above the wafer 200 to remove a gas, reaction by-products, and the like remaining in the process chamber 201 from the interior of the process chamber 201. As a result, the residual gas is removed from above the wafer 200, so that the amount of the second reactant and decomposition products remaining in the process chamber 201 can be reduced. At this time, the time for which the interior of the process chamber 201 is vacuum-exhausted is set to be, for example, within a range of 0.1 to 30 seconds.

(First Reactant Supplying Step)

Subsequently, the valve 324 is opened to allow a first reactant to flow into the gas supply pipe 320. The flow rate of the first reactant is regulated by the MFC 322, and the first reactant is supplied from the gas supply hole 420a of the nozzle 420 into the process chamber 201 and is exhausted through the exhaust pipe 231.

At this time, the APC valve 243 is regulated to set the internal pressure of the process chamber 201 to be, for example, within a range of 1 to 3,990Pa. The supply flow rate of the first reactant controlled by the MFC 322 is set to be, for example, within a range of 0.1 to 30slm. The time for which a second reducing gas is supplied to the wafer 200 is set to be, for example, within a range of 0.01 to 30 seconds.

At this time, the first reactant is supplied to the wafer 200. Here, for example, a nitriding agent can be used as the first reactant. The nitriding agent is a gas containing nitrogen. Specifically, a gas containing nitrogen and hydrogen, such as $NH_3$, $N_2H_2$, $N_3H_3$, and $N_2H_4$, can be used. In the following, an example in which an $NH_3$ gas is used as the first reactant will be described. When $NH_3$ is supplied, it undergoes a substitution reaction with at least a portion of the Ti-containing layer formed on the wafer 200. During the substitution reaction, Ti contained in the Ti-containing layer and N contained in the $NH_3$ gas combine with each other to form a TiN layer on the wafer 200. Specifically, $TiCl_x$ adsorbed on the wafer 200 reacts with $NH_3$ to form a TiN film on the wafer 200, improving the coverage of the TiN film. In addition, during the substitution reaction, reaction by-products such as HCl, ammonium chloride ($NH_4Cl$), and $H_2$ are generated.

(Inert Gas Supply)

After a predetermined time elapsed since the supply of the first reactant was started, the valve 324 is closed to stop the supply of the first reactant. At this time, the valves 514, 524, 534, and 544 are opened to allow an inert gas to flow into the gas supply pipes 510, 520, 530, and 540, respectively. That is, the inert gas is supplied into the process chamber 201.

At this time, the APC valve 243 is regulated to set the internal pressure of the process chamber 201 to be, for example, within a range of 1 to 3,990Pa. The supply flow rate of the inert gas controlled by the MFCs 512, 522, 532, and 542 is set to be, for example, within a range of 0.1 to 30slm. At this time, the time for which the inert gas is supplied to the wafer 200 is set to be, for example, within a range of 0.01 to 30 seconds.

At this time, the inert gas is supplied into the process chamber 201. This makes it possible to reduce the first reactant, which has not unreacted or has contributed to the film formation, and reaction by-products remaining in the process chamber 201.

(Exhausting Step)

After a predetermined time elapsed since the supply of the inert gas was started, the valves 514, 524, 534, and 544 are closed to stop the supply of the inert gas. At this time, the APC valve 243 of the exhaust pipe 231 is opened to exhaust the interior of the process chamber 201 by the pump 246. As a result, a residual gas is removed from above the wafer 200 to remove the first reactant, which has not unreacted or has contributed to the film formation, reaction by-products, and the like remaining in the process chamber 201 from the interior of the process chamber 201. At this time, the time for which the interior of the process chamber 201 is exhausted is set to be, for example, within a range of 0.1 to 30 seconds.

(Performing Predetermined Number of Times)

In the film-forming step, the above-described precursor supplying step to exhausting step are performed a predetermined number of times (X times, see FIG. 5), one or more times, to form a first element-containing film having a predetermined thickness on the wafer 200. Here, for example, a titanium nitride (TiN) film is formed.

(Second Regulation Step)

As shown by a broken line in flow example 2 of FIG. 4, a second regulation step may be performed after the film-forming step. By performing this second regulation step, the state of the nucleation inhibitor can be regulated after the film formation. For example, the amount of nucleation inhibitor can be regulated such that most or some of nucleation inhibitors are removed. In addition, the nucleation inhibitor present on the wafer 200 can be terminated. In addition, the nuclei of a film adhered to the nucleation inhibitor can be removed. By removing most of the nucleation inhibitors and performing the nucleation inhibitor forming step again, the nucleation inhibitor can be formed again on the surface of the wafer 200. This makes it possible to maintain the locations (areas) on the surface of the wafer 200 where nuclei do not grow. In addition, by removing some of nucleation inhibitors and continuing to form the film, new film nuclei can be generated in the locations (areas) where the nucleation inhibitor is no longer present. Here, in the second regulation step, the amount of nucleation inhibitor is regulated to a second amount. The second amount is less than the first amount. That is, the first amount is greater than the second amount.

Note that the second regulation step may be incorporated into the gas supplying sequence of the film-forming step. For example, the amount of nucleation inhibitor can be regulated by appropriately regulating the supply conditions of the first reactant in the film-forming step.

The second regulation step can be performed under the same procedures and conditions as the first regulation step. The conditions of the second regulation step may be different from those of the first regulation step. For example, the amount of nucleation inhibitor on the wafer 200 can be set such that the first amount is greater than the second amount by making the amount of regulating agent supplied in the second regulation step smaller than the amount of regulating agent supplied in the first regulation step.

In addition, in the "predetermined number of times" configuration of FIG. 4, it is determined whether or not the configuration up to that point is performed a predetermined number of times, and the flow is branched according to the determination result. Here, the predetermined number of times is an integer of 1 or 2 or more. Regarding the branching, in the predetermined number of times 1 of flow example 1, it is determined whether or not the nucleation inhibitor forming step and the first regulation step have been performed a predetermined number of times. In the predetermined number of times 2, it is determined whether or not the nucleation inhibitor forming step, the first regulation step, the predetermined number of times 1, and the film-forming step have been performed a predetermined number of times. In the predetermined number of times 3 of flow example 2, the same determination as in the predetermined number of times 1 may be performed. In the predetermined number of times 4, it is determined whether or not the nucleation inhibitor forming step, the first regulation step, the predetermined number of times 3, the film-forming step, and the second regulation step have been performed a predetermined number of times. In addition, as shown by the broken line, in the predetermined number of times 4, it may be determined whether or not the film-forming step and the second regulation step have been performed a predetermined number of times. If it is determined that the film-forming step and the second regulation step have not been performed a predetermined number of times (N in flow example 2), the film-forming step and the second regulation step may be repeated until they have been performed a predetermined number of times. Each time the film-forming step and the second regulation step are performed, the amount of nucleation inhibitor on the wafer 200 can be reduced. As a result, the crystal density of the film can be improved.

In addition, the process may be configured as in flow example 3 of FIG. 4. In flow example 3, a first nucleation inhibitor forming step, the film-forming step, a second nucleation inhibitor forming step, the first regulation step, the predetermined number of times 5, the film-forming step, and the predetermined number of times 6 are performed sequentially. The first nucleation inhibitor forming step is the same step as the nucleation inhibitor forming step in flow example 1. The second nucleation inhibitor forming step may not be performed. The second nucleation inhibitor forming step may be performed under the same procedures and conditions as in the first nucleation inhibitor forming step. The second nucleation inhibitor forming step may be configured to be performed under different conditions from the first nucleation inhibitor forming step. As in flow example 3, by performing the film-forming step after the first nucleation inhibitor forming step, a film is formed in a state in which the amount of nucleation inhibitor is large on the surface of the wafer 200, so that the amount of nuclei of the film formed on the surface of the wafer 200 can be reduced. As a result, crystals can be grown and the size of the crystal grains can be increased. The film-forming step performed immediately after the first nucleation inhibitor forming step can also be referred to as a nucleation step.

In addition, the process may be configured as in flow example 4 of FIG. 4. In flow example 4, the nucleation inhibitor forming step is performed during the film-forming step. By performing X cycles of the film-forming step shown in FIG. 5, some of nucleation inhibitors may be removed. In this case, as some of nucleation inhibitors are removed, the number of nuclei of the film formed increases. By performing the nucleation inhibitor forming step during the film-forming step, it is possible to suppress an increase in the number of nuclei of the film and promote the growth of the nuclei of the film. As a result, it is possible to increase the size of the crystal grains. Performing the nucleation inhibitor forming step during the film-forming step means, for example, performing the nucleation inhibitor forming step every X cycles or every multiple cycles.

(Purging and Returning to Atmospheric Pressure)

An inert gas is supplied from each of the gas supply pipes 510 to 540 into the process chamber 201 and is exhausted through the exhaust pipe 231. The inert gas acts as a purge gas, whereby the interior of the process chamber 201 is purged with the inert gas to remove a gas and reaction by-products remaining in the process chamber 201 from the interior of the process chamber 201. After that, the internal atmosphere of the process chamber 201 is substituted with the inert gas, and the internal pressure of the process chamber 201 is returned to the normal pressure.

(Wafer (Substrate) Unloading)

After that, the SC 219 is moved down by the BE 115 to open the lower end of the outer tube 203. Then, the processed wafers 200 supported by the boat 217 are unloaded from the lower end of the outer tube 203 to the outside of the outer tube 203. After that, the processed wafers 200 are discharged from the boat 217.

(3) Effects of the Present Embodiments

According to the embodiments, one or more of the effects set forth below can be achieved.

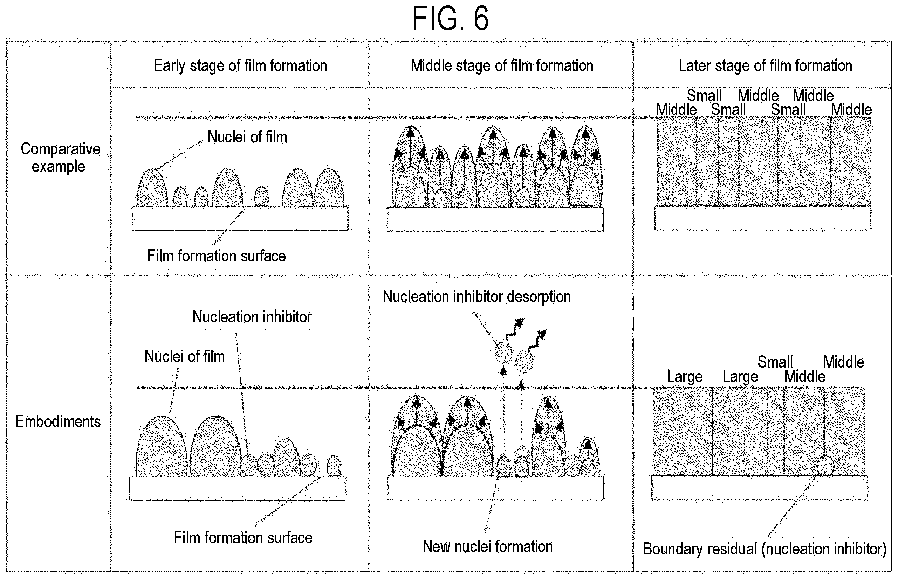

(a) By forming a nucleation inhibitor on the wafer 200 and forming a film, the crystals can be made larger. FIG. 6 shows a growth mechanism of a film generated on the wafer 200 in the embodiments and a growth mechanism of a comparative example (a case where a film is formed without forming a nucleation inhibitor). In the early stage of film formation in the comparative example in FIG. 6, a relatively large number of nuclei of the film are formed on the film formation surface. This is because there is nothing to inhibit (suppress) the formation of the nuclei. In this state, as the film formation progresses, the nuclei of the film grow around respective nuclei. In the middle stage of film formation, the nuclei of the film collide with each other, so that the growth of the nuclei in the horizontal direction with respect to the film formation surface in the figure is suppressed. As a result, the growth in the vertical direction with respect to the film formation surface increases. In the later stage of film formation (completion of film formation), as a result of the growth of the nuclei of the film not progressing in the horizontal direction, the size of the crystals in the horizontal direction with respect to the film formation surface becomes smaller than in the embodiment. In the embodiments, the presence of the nucleation inhibitor on the film formation surface results in no nuclei of the film being formed in the early stage of film formation as compared to the comparative example. As a result, the number of film nuclei can be reduced. In the middle stage of film formation in the embodiments, the collisions between film nuclei are less than in the comparative example, and the growth continues in the horizontal direction relative to the film formation surface. Note that during the film-forming step (step of forming the film), the nucleation inhibitor may be desorbed due to the supply of the first reactant, etc. New nuclei are formed at the locations where the nucleation inhibitor is desorbed. In the later stage of film formation in the embodiments (completion of film formation), the size of the crystals in the horizontal direction relative to the film formation surface can be increased as compared to the comparative example, because the collisions between film nuclei are less than in the comparative example. Note that the film formed in the embodiments may contain residual nucleation inhibitors.

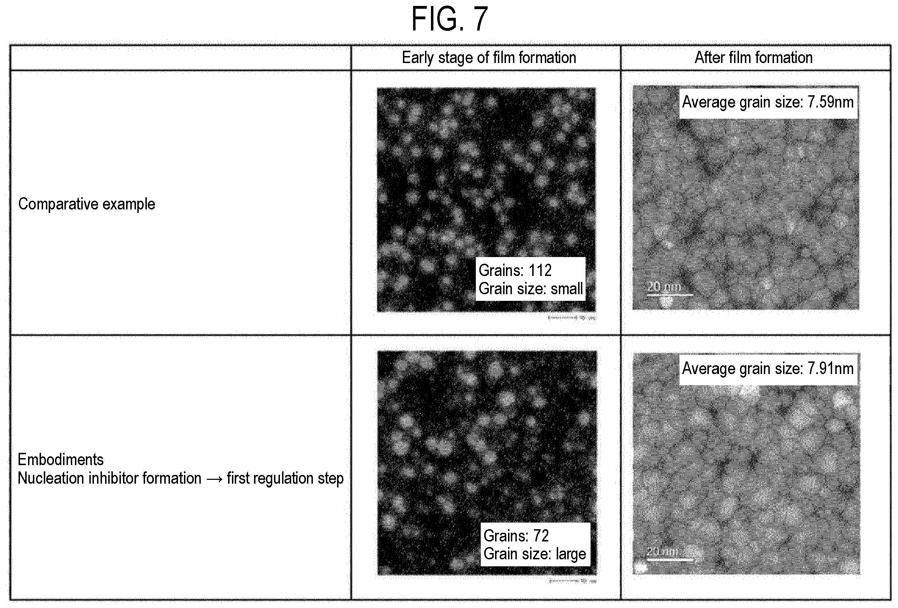

TEM images showing the state of crystals on the surface of the wafer 200 in the early stage of film formation in the comparative example and the state of crystals on the surface of the wafer 200 after film formation are shown in FIG. 7. As shown in FIG. 7, in the embodiments, the number of crystals in the early stage of film formation can be reduced as compared to the comparative example, and the average grain size can be increased after film formation.

(b) As shown in FIGS. 6 and 7, in the embodiments, a film is formed in a state where a nucleation inhibitor is present on the film formation surface. The nucleation inhibitor inhibits film formation, so that the film can be formed discontinuously. "Discontinuous" means that the crystals of the film are not continuously formed in a direction horizontal to the film formation surface.

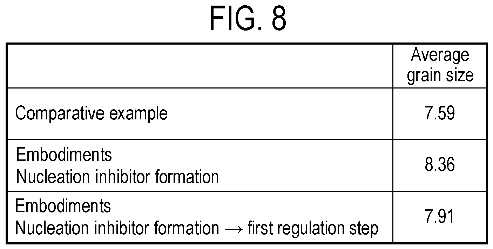

(c) By performing the first regulation step after the formation of the nucleation inhibitor, the state (amount) of nucleation inhibitor on the wafer 200 can be regulated. As a result, the grain size of the film formed on the wafer 200 can be regulated. FIG. 8 shows the average grain size of each of the comparative example, a case where a film is formed in situ after the formation of the nucleation inhibitor, and a case where a film is formed by supplying air (gas that may

contain $O_2$ and $H_2O$) after the formation of the nucleation inhibitor. By forming the nucleation inhibitor in this way, the average grain size can be increased. It is also seen that the average particle size can be varied depending on whether or not the first regulation step is performed. From this result, it can be said that the average particle size can be regulated by appropriately regulating the presence or absence of the first regulation step and the conditions of the first regulation step.

(d) The nucleation inhibitor acts as an inhibitor that inhibits film formation. When acting as the inhibitor, the nucleation inhibitor has the effect of inhibiting film formation. By performing the regulation step as in the present disclosure, the inhibitor action can be weakened, and a film can be formed even if a nucleation inhibitor is formed. Note that a state in which the inhibitor action is weakened can also be referred to as a half-inhibited state (half inhibitor). This does not mean that there is a half-inhibiting effect, but that some are in an inhibiting state and some are not in an inhibiting state. Note that the first regulation step is also referred to as forming a half-inhibitor state (substances in a half-inhibited state).

(e) As in flow example 2 of FIG. 4, by performing the film-forming step and the second regulation step a predetermined number of times (particularly two or more times), the amount of nucleation inhibitor remaining on the film formation surface of the wafer 200 can be reduced. As a result, the amount (concentration) of impurities in the film can be reduced. In addition, by reducing the amount of nucleation inhibitor, the amount of nuclei of the film can be increased in the film-forming step.

(f) As in flow example 3 of FIG. 4, by forming the film immediately after the first nucleation inhibitor forming step, the nucleation inhibitor can inhibit the formation of nuclei of the film. As a result, the amount of nuclei of the film formed in the early stage of film formation can be reduced, and the size of the nuclei (crystals) can be increased in the later stage of film formation.

(g) The size of columnar crystals in the horizontal direction relative to the film formation surface can be increased. This makes it possible to reduce the leakage path of a current (the path through which the current passes) occurring in the horizontal direction relative to the film formation surface.

(h) The size of columnar crystals in the horizontal direction relative to the film formation surface can be increased. This makes it possible to suppress the passage of elements (molecules, gases) from the surface of the formed film to the base film of the film. In other words, the barrier properties can be improved.

(i) When the film formed on the wafer 200 is a conductive film, the electrical characteristics of the conductive film can be improved by increasing the size of the crystal grains of the film.

(j) When the film formed on the wafer 200 is a TiN film, the TiN crystals are columnar. In this case, the size of the columnar crystals in the horizontal direction relative to the film formation surface can be increased. In other words, the TiN crystals in the horizontal direction can be increased, and the above-mentioned barrier properties and electrical characteristics can be improved.

(k) In flow examples 1 to 4, by not branching to the formation of the nucleation inhibitor at the predetermined number of times 2, 4, and 6 (by branching to the film formation in the case of N in flow examples 1 to 4), the growth rate of the film formed on the wafer 200 can be increased. This is because the nucleation inhibitor has the effect of inhibiting the film formation. In addition, depending on the material forming the nucleation inhibitor, it has the effect of etching (removing) a portion of the formed film, so that the film may be etched. In addition, the film formation and the etching with the nucleation inhibitor may be configured to be performed alternately. Depending on the film to be formed, as shown in FIG. 6, there may be a difference in the size of the nuclei of the film formed in the early stage of film formation between large and small ones. If the film is formed in this way with the nuclei of different sizes, the surface roughness of the film formed on the wafer 200 may be large. By performing the film formation and the etching alternately, the surface roughness of the film can be made relatively small.

(4) Other Embodiments

The embodiments of the present disclosure are specifically described above. However, the present disclosure is not limited to the above-described embodiments, and various modifications can be made within the scope of the gist of the present disclosure.

In addition, in the above-described embodiments, a case where a nitriding agent is used as the first reactant has been described, but the present disclosure is not limited thereto. For example, when forming a film of a metal element, instead of a nitride film, as a film to be formed on the substrate, a nitrogen-free hydrogen-containing gas may be used as the first reactant. Examples of the nitrogen-free hydrogen-containing gas may include a $H_2$ gas, a deuterium ($D_2$) gas, etc. In addition, an oxidizing agent may be used as the first reactant when forming an oxide film. As the oxidizing agent, a gas containing oxygen can be used. Specifically, at least one of $O_2$, $O_3$, $H_2O$, $H_2+O_2$, $H_2O_2$, and $N_2O$ can be used as the first reactant. Note that each of the nitriding agent, the reducing agent, and the oxidizing agent can be a gas obtained by activating at least one of the gases disclosed herein.

It is preferable that a process recipe (a program in which the processing procedure, process conditions, and the like are written) used for forming these various types of thin films is prepared individually (in plural) according to the substrate processing contents (film type, composition ratio, film quality, film thickness, processing procedure, process conditions, and the like of a thin film to be formed). Then, when starting the substrate processing, it is preferable that a proper process recipe is appropriately selected from a plurality of process recipes according to the contents of the substrate processing. Specifically, it is preferable that the plurality of process recipes (program products) individually prepared according to the contents of the substrate processing are stored (installed) in advance in the memory 121c included in the substrate processing apparatus via a telecommunication line or a recording medium (the external memory 123) on which the process recipes are recorded. Then, when starting the substrate processing, it is preferable that the CPU 121a included in the substrate processing apparatus appropriately selects a proper process recipe from the plurality of process recipes stored in the memory 121c according to the contents of the substrate processing. With this configuration, it is possible to form thin films of various film types, composition ratios, film qualities, and film thicknesses with a single substrate processing apparatus in a versatile and well-reproducible manner. Further, it is possible to reduce an operator's operation burden (input burden of processing procedure, process conditions, etc.) and to quickly start the substrate processing while avoiding an operation error.

Further, the present disclosure can also be realized by, for example, changing a process recipe of the existing substrate processing apparatus. When changing a process recipe, the process recipe according to the present disclosure may be installed on the existing substrate processing apparatus via a telecommunications line or a recording medium on which the process recipe is recorded, or it is also possible to change a process recipe itself of the existing substrate processing apparatus to the process recipe according to the present disclosure by operating an input/output device of the existing substrate processing apparatus.

In addition, the present disclosure can be used, for example, in word line portions of a NAND-type flash memory or DRAM having a three-dimensional structure.

Further, in the above-described embodiments and modifications, an example has been described in which a film is formed using a batch-type substrate processing apparatus capable of processing a plurality of substrates at a time. However, the present disclosure is not limited to the above-described embodiments, but can also be suitably applied to a case where a film is formed using a single-wafer substrate processing apparatus capable of processing a single substrate or several substrates at a time. In addition, an example in which a film is formed using a substrate processing apparatus provided with a hot-wall-type process furnace has been described in the above-described embodiments. However, the present disclosure is not limited to the above-described embodiments, but can also be suitably applied to a case where a film is formed using a substrate processing apparatus provided with a cold-wall-type process furnace.

In the above-described embodiments, an example has been described in which the above-described processing sequence is performed in the same process chamber of the same processing apparatus (in-situ). However, the present disclosure is not limited to the above-described embodiments. For example, any step and any other step of the above-described processing sequence may be performed in different process chambers of different processing apparatuses (ex-situ), or may be performed in different process chambers of the same processing apparatus.

Even in the case of using these substrate processing apparatuses, each process can be performed according to the same processing procedures and process conditions as those in the above-described embodiments and modifications, and the same effects as those of the above-described embodiments and modifications can be obtained.

The above-described embodiments and modifications can be used in proper combinations. The processing procedures and process conditions at this time can be the same as, for example, those of the above-described embodiments and modifications.

According to the present disclosure in some embodiments, it is possible to regulate the characteristics of a film.

While certain embodiments have been described, these embodiments have been presented by way of example only, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

**Claims**

1.    A method of processing a substrate (200), comprising:

a) forming a nucleation inhibitor discontinuously, by supplying a first agent to the substrate (200);
b) forming a film on a surface of the substrate (200), the surface on which the nucleation inhibitor is formed;
c) regulating an amount of the nucleation inhibitor to a first amount; and
d) performing a), b), and c) a predetermined number of times.

2. The method of Claim 1, wherein c) is performed after a).

3. The method of Claim 1 or 2, wherein a) and c) are performed a plurality of times.

4. The method of any one of Claims 1 to 3, further comprising: e) regulating the amount of the nucleation inhibitor to a second amount.

5. The method of Claim 4, wherein e) is performed during b).

6. The method of Claim 4 or 5, wherein the first amount is larger than the second amount.

7. The method of any one of Claims 1 to 6, wherein a) is performed during b).

8. The method of any one of Claims 1 to 7, wherein in a), an agent containing a halogen element is supplied to the substrate (200) and the nucleation inhibitor containing the halogen element is formed.

9. The method of Claim 8, wherein in d), an amount of the halogen element is regulated.

10. The method of any one of Claims 1 to 9, wherein b) includes:

b-1) supplying a precursor to the substrate (200); and
b-2) supplying a first reactant to the substrate (200).

11. The method of any one of Claims 1 to 10, wherein in c), a modifying agent is supplied to the substrate (200).

12. The method of any one of Claims 1 to 11, wherein in b), the film is formed discontinuously.

13. A method of manufacturing a semiconductor device, comprising the method of any one of Claims 1 to 12.

14. A program that causes, by a computer, a substrate processing apparatus (10) to perform a process comprising:

a) forming a nucleation inhibitor discontinuously by supplying a first agent to a substrate (200);
b) forming a film on a surface of the substrate (200), the surface on which the nucleation inhibitor is formed;
c) regulating an amount of the nucleation inhibitor to a first amount; and
d) performing a), b), and c) a predetermined number of times.

15. A substrate processing apparatus (10) comprising:

a first supplier (440) configured to supply a first agent to a substrate (200);
a second supplier (410, 420, 430) configured to supply a second gas to the substrate (200); and
a controller (121) configured to be capable of controlling the first supplier (440) and the second supplier (410, 420, 430) to perform a process including:

a) forming a nucleation inhibitor discontinuously by supplying the first agent to the substrate (200);
b) forming a film on a surface of the substrate (200), the surface on which the nucleation inhibitor is formed;
c) regulating an amount of the nucleation inhibitor to a first amount; and
d) performing a), b), and c) a predetermined number of times.

FIG. 1

# FIG. 2

# FIG. 3

- 121
  - 121a CPU
  - 121b RAM
  - 121c Memory
  - 121d I/O port
- 123 External memory
- 122 Input/output device

- Mass flow controller — 312, 322, 332, 342, 512, 522, 532, 542
- Valve — 314, 324, 334, 344, 514, 524, 534, 544
- Pressure sensor — 245
- APC valve — 243
- Vacuum pump — 246
- Heater — 207
- Temperature sensor — 263
- Rotator — 267
- Boat elevator — 115

EP 4 624 624 A2

FIG. 4

Substrate loading → Pressure regulation/temperature regulation → Substrate processing → Purging/Returning to Atmospheric Pressure → Substrate unloading

<Flow example 1>

Forming nucleation inhibitor → First regulation step → Predetermined number of times 1 (N → loop back; Y) → Forming film → Predetermined number of times 2 (N → loop back; Y)

<Flow example 2>

Forming nucleation inhibitor → First regulation step → Predetermined number of times 3 (N → loop back; Y) → Forming film [Second regulation step] → Second regulation step → Predetermined number of times 4 (N → loop back; Y)

<Flow example 3>

Forming first nucleation inhibitor → Forming film → Forming second nucleation inhibitor → First regulation step → Predetermined number of times 5 (N → loop back; Y) → Forming film → Predetermined number of times 6 (N → loop back; Y)

<Flow example 4>

Forming nucleation inhibitor → First regulation step → Predetermined number of times 1 (N → loop back; Y) → Forming film [Forming nucleation inhibitor] → Predetermined number of times 2 (N → loop back; Y)

# FIG. 5

FIG. 6

# FIG. 7

|  | Early stage of film formation | After film formation |
|---|---|---|
| Comparative example | Grains: 112<br>Grain size: small | Average grain size: 7.59nm<br>20 nm |
| Embodiments<br>Nucleation inhibitor formation → first regulation step | Grains: 72<br>Grain size: large | Average grain size: 7.91nm<br>20 nm |

EP 4 624 624 A2

## FIG. 8

|  | Average grain size |
|---|---|
| Comparative example | 7.59 |
| Embodiments<br>Nucleation inhibitor formation | 8.36 |
| Embodiments<br>Nucleation inhibitor formation → first regulation step | 7.91 |

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2024050332 A